Europäisches Patentamt

European Patent Office

Office européen des brevets

(11) Veröffentlichungsnummer: **0 386 458**
**A1**

## (12) EUROPÄISCHE PATENTANMELDUNG

(21) Anmeldenummer: **90102056.0**

(22) Anmeldetag: **02.02.90**

(51) Int. Cl.5: **C04B 41/90, H05K 3/38, H01L 21/48**

(30) Priorität: **04.03.89 DE 3907005**

(43) Veröffentlichungstag der Anmeldung:
**12.09.90 Patentblatt 90/37**

(84) Benannte Vertragsstaaten:
**CH DE FR GB IT LI NL SE**

(71) Anmelder: **CONTRAVES AG**
**Schaffhauserstrasse 580**
**CH-8052 Zürich(CH)**

(72) Erfinder: **Feurer, Ernst, Dr.**
**Im Riedli 10**
**D-7906 Blaustein-Markbronn(DE)**
Erfinder: **Schoenfeld, Erwin**
**Im Rüteli 21**
**CH-5405 Baden(CH)**
Erfinder: **Sutcliffe, Emile, Dr.**
**Pilgerstrasse 32**
**CH-5405 Baden(CH)**

(54) **Verfahren zum Herstellen von Dünnschichtschaltungen mit Zinnstrukturen.**

(57) Zum Herstellen von Dünnschichtschaltungen mit Zinnstrukturen auf einem Substrat mit einer nichtleitenden Oberfläche (7) wird als erstes die Oberfläche des Substrats mittels einer Plasmabehandlung vorgereinigt. Dann wird die Oberfläche mit einer Leiterbahn beschichtet, indem zuerst eine haftvermittelnde Grundmetallisierung aus CuCr (3) ganzflächig aufgesputtert wird und diese dann gemäss einem semi-additiven Verfahren selektiv mit einer Leiterbahn (6) aus einem gutleitenden Metall galvanisch verstärkt wird. Um die Leiterbahn selektiv mit Zinnstrukturen im Sinn der semi-additiven Technik zu beschichten, wird die Leiterbahn erneut mit Photolack (8) teilweise abgedeckt und dann galvanisch mit Zinn oder mit einer Zinnlegierung (9) verstärkt. Schliesslich wird der Photolack entfernt und ein nicht verstärkter Bereich der Grundmetallisierung weggeätzt.

FIG.4

FIG.5

FIG.6

FIG.7

FIG. 8

FIG. 9

2

**Verfahren zum Herstellen von Dünnschichtschaltungen mit Zinnstrukturen**

**Technisches Gebiet**

Die Erfindung betrifft ein Verfahren zum Herstellen von Dünnschichtschaltungen mit Zinnstrukturen, bei welchem ein Substrat mit einer nichtleitenden Oberfläche gemäss einem semi-additiven Verfahren selektiv mit einer Leiterbahn beschichtet wird und dann Zinnstrukturen auf die Leiterbahn aufgebracht werden.

**Stand der Technik**

Ein Verfahren zum Herstellen von Dünnschichtschaltungen auf Keramiksubstraten offenbart das Schweizer Patentgesuch CH-5062/87-2. Dieses Verfahren zeichnet sich aus durch das Aufsputtern einer kombinierten Haft/Leitschicht auf das Substrat und ein selektives Verstärken dieser Schicht mit Cu. Die Verwendung der kombinierten Haft/Leitschicht vereinfacht den im Rahmen der selektiven Verstärkung nötigen Aetzprozess beträchtlich.

Es besteht nun das Bedürfnis, Dünnschichtschaltungen mit Lötpads herzustellen. Es sind mehrere Wege bekannt, welche zu diesem Ziel führen. Eine erste Möglichkeit besteht darin, Zinn oder eine Zinnlegierung stromlos chemisch abzuscheiden. Dieses Abscheiden geht jedoch sehr langsam vor sich. Eine weitere Möglichkeit ist der Siebdruck einer Zinn- oder Zinnlegierungspaste. Während auf diese Weise schnell Strukturen von hinreichender Dicke erzeugt werden können, muss dagegen der Nachteil einer geringen Strukturauflösung in Kauf genommen werden. Ausserdem stören die beim Siebdruck notwendigen organischen Zusätze. Bei anderen konventionellen Verfahren müssen die im Dünnschichtaufbau vorhandenen unedleren Metalle vor dem Aetzen der Haftschicht, welche für die Haftung zwischen Leiterbahn und nichtleitendem Substrat sorgt, zusätzlich mit einem Schutzlack versehen werden.

Ein bedeutsamer Aspekt von Herstellungsverfahren für Dünnschichtschaltungen ist ihre Tauglichkeit für die Herstellung von Mehrlagenschaltungen. Wie aus der Druckschrift "Multilayering with Polyimide Dielectric and Metallo-organic Conductors" P.H. Nguyen et al., Solid State Technology, September 1986, bekannt ist, eignen sich Polyimidfilme wegen ihrer geringen Dielektrizitätskonstanten und ihrer Fähigkeit zur Bildung von hochauflösenden Strukturen besonders gut als isolierende Zwischenschichten in Mehrlagenschaltungen. Dieser Tatsache hat ein zukünftiges Verfahren Rechnung zu tragen.

Ein Verfahren zum Herstellen von Mehrlagenschlatungen ist z.B. aus der Veröffentlichung "Advanced Copper/Polymer/Hybrid Technology", Hayato Takasago et al., Materials & Electronic Devices Laboratory, Mitsubishi Electric Company, 1986 IEEE, bekannt. Dabei werden auf ein $Al_2O_3$ Substrat nach einem sog. voll-additiven Prozess eine erste Schicht von Leiterbahnen und dann nach einem sog. semi-additiven Prozess weitere Lagen aufgebracht, welche jeweils durch eine Polyimidschicht voneinander isoliert sind. Um die Cu-Leiterbahnen aufbringen zu können, müssen die isolierenden Oberflächen jeweils mit Katalysatoren vorbehandelt werden. Ein verfahrensökonomischer Nachteil dieses Verfahrens liegt ausserdem darin, dass für verschiedene Lagen der Mehrlagenschaltung unterschiedliche Herstellungsprozesse erforderlich sind.

**Darstellung der Erfindung**

Aufgabe der Erfindung ist es, ein Verfahren der eingangs genannten Art anzugeben, welches sich zum Herstellen von Dünnschichtschaltungen auf keramischen wie auch auf nichtkeramischen Substraten, wie z.B. Polyimid, eignet und die beim Stand der Technik vorhandenen Nachteile vermeidet. Das Verfahren soll sich möglichst mit bekannten Mitteln und mit geringem Aufwand durchführen lassen.

Erfindungsgemäss besteht die Lösung darin, dass bei einem Verfahren der eingangs genannten Art

a) die Oberfläche des Substrats mittels einer Plasmabehandlung vorgereinigt wird,

b) eine haftvermittelnde Grundmetallisierung aus CuCr ganzflächig auf die Oberfläche aufgesputtert wird,

c) die Grundmetallisierung gemäss der semi-additiven Technik selektiv mit einem gutleitenden Metall galvanisch verstärkt wird,

d) die Leiterbahn selektiv mit Zinnstrukturen gemäss der semi-additiven Technik beschichtet wird, indem zumindest die Leiterbahn mit einem Photolack selektiv abgedeckt, dann galvanisch mit Zinn oder mit einer Zinnlegierung verstärkt wird und der Photolack entfernt wird, und

e) dass schliesslich ein nicht verstärkter Bereich der Grundmetallisierung mit alkalischen Aetzmitteln weggeätzt wird.

Vorzugsweise werden ausserdem folgende Schritte durchgeführt:
- Vorreinigen der Oberfläche des Substrats mit einer Argon-Plasmabehandlung;
- Entfernen von Cr-Resten vor dem galvanischen Verstärken mit einem Chromätzmittel;
- Wegätzen der nicht-verstärkten Bereiche der Grundmetallisierung mit einem ammoniumchloridhaltigen Aetzmittel.

Das erfindungsgemässe Verfahren eignet sich insbesondere zum Aufbringen von Leiterbahnen mit Lötpads auf Materialien wie:
- Polyimid,
- eine mit einem photosensitiven Polyimid beschichtete Keramik,
- Fluorpolymer oder thermoplastischer Kunststoff,
- Glas, Quarz und
- Dünnschicht- und Dickschichtkeramiken.

Zum Herstellen einer Mehrlagenschaltung wird eine Keramik als Substrat verwendet, auf welcher im Sinn der Mehrlagentechnik abwechslungweise strukturierte Leiterbahnen und isolierende Schichten aus Polyimid aufgebracht werden. Die oberste Leiterbahnlage wird nach dem erfindungsgemässen Verfahren mit gewünschten Zinnstrukturen versehen.

Aus den abhängigen Patentansprüchen ergeben sich weitere Ausführungsformen der Erfindung

Kurze Beschreibung der Zeichnung

Nachfolgend soll die Erfindung anhand von Ausführungsbeispielen im Zusammenhang mit der Zeichnung näher erläutert werden. Es zeigen:

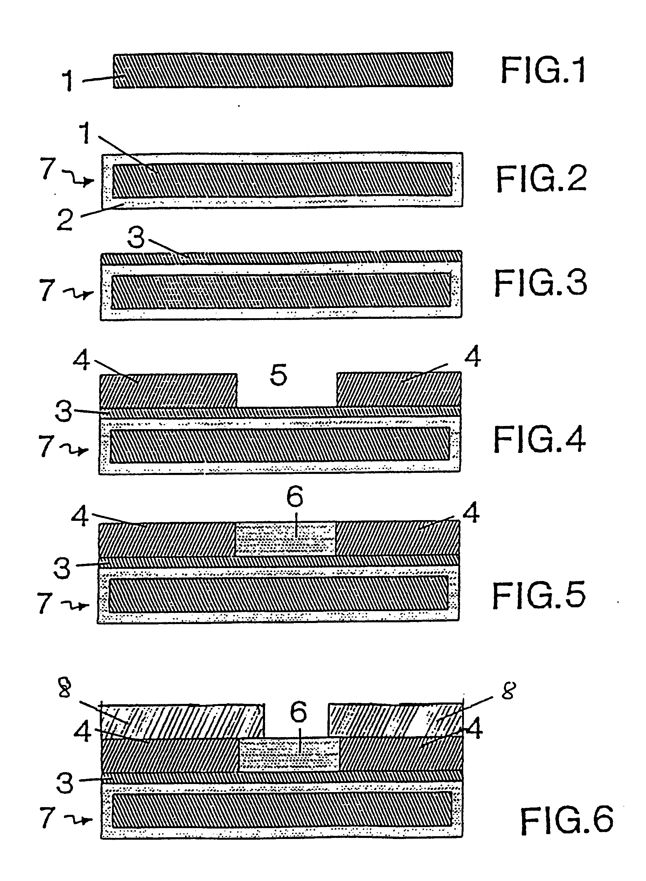

Fig. 1 - 9 eine schematische Darstellung der Schritte eines erfindungsgemässen Verfahrens.

Die in der Zeichnung verwendeten Bezugszeichen und deren Bedeutung sind in der Bezeichnungsliste zusammenfassend tabelliert.

**Wege zur Ausführung der Erfindung**

Ausgangspunkt einer bevorzugten Ausführungsform ist eine Keramik 1 (Fig. 1). Diese wird mit einer Polyimidschicht 2 von z.B. 15 $\mu$m Dicke bedeckt (Fig. 2). Dies lässt sich z.B mit einem Spin-on Verfahren, wie es in der eingangs zitierten Schrift von P.H. Nguyen et al. beschrieben wird, erreichen. Damit liegt ein Substrat 7 mit einer nicht-leitenden, nichtkeramischen Oberfläche vor.

Die Oberfläche des Substrats 7 wird nun sorgfältig gewaschen und entfettet. Dann wird das Substrat 7 in eine Vakuumanlage gebracht, in welcher die Oberfläche einer Argon-Plasmabehandlung unterworfen wird. Bei dieser Vorreinigung werden einerseits Verschmutzungen, welche noch auf der Oberfläche haften, entfernt. Andererseits wird bei Polyimid auch die Oberfläche aufgerauht. Dieses sogenannte Sputterätzen sollte etwa 5 Minuten dauern.

Als nächstes wird ganzflächig eine Grundmetallisierung 3 aus CuCr mit einer Dicke von ca. 0.2 - 1 $\mu$m aufgesputtert (Fig.3). Mit Vorteil wird aus einem einzigen Target gesputtert, welches aus einer entsprechenden Mischung oder Legierung von Cu und Cr besteht. Die Grundmetallisierung enthält zum überwiegenden Teil Cu. Cr macht nur einen kleinen Anteil von etwa 5 - 15 Atom-% der Schicht aus. Weitere Einzelheiten betreffend Zusammensetzung und Herstellung der genannten Grundmetallisierung 3 sind dem eingangs zitierten Schweizer Patentgesuch CH-5062/87-2 zu entnehmen.

Nun folgt die selektive Beschichtung mit Cu im Sinn der semi-additiven Technik. Dazu wird die Grundmetallisierung 3 selektiv mit einem Photolack 4 abgedeckt (Fig. 4). Je nach Feinheit der zu erreichenden Strukturen wird ein Flüssig-oder Trokkenresist verwendet.

Es ist darauf zu achten, dass Cr-Reste, welche allenfalls auf der nicht mit Photolack abgedeckten Oberfläche der Grundmetallisierung zurückgeblieben sind, entfernt werden, damit die Haftung einer nachfolgend aufzubringenden Leiterbahn gewährleistet ist. Zu diesem Zweck wird die Grundmetallisierung 3 mit einem gebräuchlichen Chrom-Aetzmitteln angeätzt.

Ein nicht vom Photolack 4 abgedeckter Bereich 5 der Grundmetallisierung 3 wird nun galvanisch mit Cu verstärkt (Fig. 5). Dadurch entstehen die gewünschten Leiterbahnen 6, welche typischerweise eine Dicke von z.B. 5 $\mu$m haben.

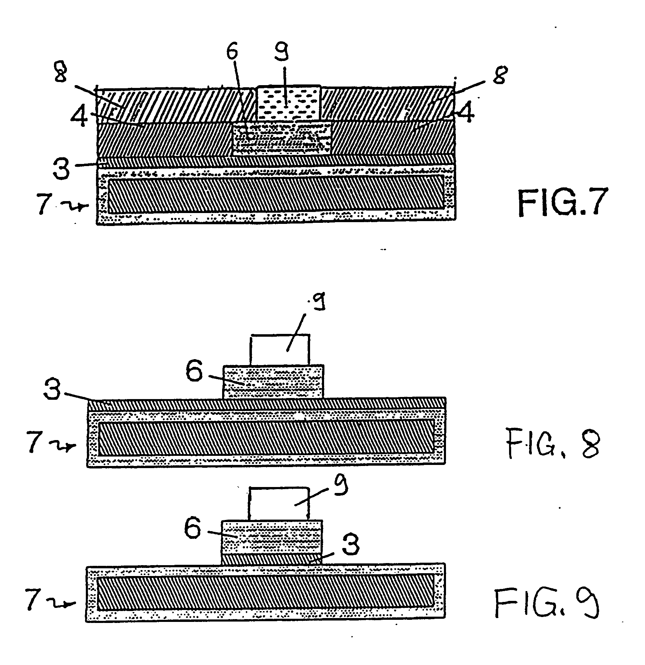

Als nächstes wird, ebenfalls gemäss der Semiadditiv-Technik, eine gewünschten Zinnstruktur gebildet. Es wird deshalb erneut selektiv Photolack 8 aufgebracht und zwar so, dass in einem oder mehreren Bereichen die Leiterbahn 6 frei bleibt (Fig.6). Dann wird die Leiterbahn 6 in den nicht durch Photolack 8 abgedeckten Bereichen galvanisch mit PbSn verstärkt (Fig.7). Die resultierende Zinnstruktur 9 ist z.B. eine Schicht mit einer Höhe von etwa 20 $\mu$m und einer Feinheit von etwa 50 $\mu$m.

Im nächsten Schritt wird der Photolack 4, 8 entfernt (Fig.8).

Der chemische Fertigungsablauf endet mit dem Wegätzen der Grundmetallisierung 3 in den Bereichen, die zuvor mit Photolack 4 bedeckt waren und deshalb nicht mit Cu verstärkt worden sind (Fig. 9). Für diese Aetzung wird ein alkalisches, ammoniumchloridhaltiges Aetzmittel eingesetzt. Damit Reste von Cr, welche beim Wegätzen der Grundmetallisierung 3 zurückgeblieben sind, entfernt werden, folgt noch eine Aetzung in Kalium-Hexacyanoferrat während etwa 10 s.

Der Vorteil der Erfindung ergibt sich im besonderen aus der Verwendung einer CuCr Grundmetallisierung. Diese lässt sich alkalisch ätzen. Damit treten beim Vorhandensein unedler Metalle keine Probleme auf. Bei der konventionellen Dünnschichttechnik, welche eine gesputterte NiCr-Haftschicht und eine darübergesputterte Cu-Leitschicht anstelle der alleinigen CuCr-Haft/Leitschicht verwendet, besteht nämlich das Problem, dass sich die NiCr-Haftschicht in Gegenwart von SnPb nicht ätzen lässt, da die entsprechenden Aetzmittel (z.B. Cerammoniumnitrat, heisse Salzsäure etc.) bevorzugt das unedlere SnPb angreifen.

Ein weiterer, zentraler Punkt ist die Art der Abscheidung der Zinnstrukturen. Sie erfolgt galvanisch und fügt sich damit nahtlos in die Herstellung der Leiterbahnen ein.

Im folgenden werden nun einige weitere, vorteilhafte Ausführungsformen der Erfindung beschrieben.

Als Substratmaterialien eignen sich neben Polyimid auch Keramiken (z.B. Aluminiumoxid), Silizium, Glas und Quarz.

Es ist deshalb nicht zwingend, dass die Keramik als erstes mit Polyimid bedeckt wird. Es kann sogar vorteilhaft sein, darauf zu verzichten und die Leiterbahn direkt auf die Keramik aufzubringen. Die Fig. 2 zeigt einfach den verfahrenstechnisch relevanten Zustand der Oberfläche, wie er z.B. auch vor dem Aufbringen der obersten Lage einer Mehrlagenschaltung vorliegt. Für das Verfahren ist es nämlich nicht von Bedeutung, ob unter der Polyimidschicht die nackte Keramik oder eine oder mehrere Leiterbahnstrukturen vorhanden sind.

Die Leiterbahnen können ebensogut aus einem anderen gutleitenden Metall wie z.B. Au, Sn oder einer Sn-Legierung bestehen. Ebenso kann die als Lötpad verwendete Zinnstruktur wahlweise aus Zinn oder aus einer Zinnlegierung bestehen.

Wenn eine Dickschichtkeramik als Substratmaterial verwendet wird, muss das mit der ganzflächigen Grundmetallisierung bedeckte Substrat in einem Vakuumofen bei ca. 400 °C ausgeheizt werden. Damit kann einer Blasenbildung vorgebeugt werden.

Im Hinblick auf Schaltungen in Mehrlagentechnik besonders bedeutsam sind photosensitive Polyimidschichten als Substratoberfläche. Zur Herstellung solcher Schaltungen werden abwechslungsweise Leiterbahnlagen und Polyimidfilme, welche mit den erforderlichen Durchkontaktierungen versehen werden, aufgebracht. Die erste Leiterbahnlage wird dann vorzugsweise direkt auf die Keramik aufgebracht. Bei der obersten Leiterbahnlage der Schaltung können dann gemäss dem erfindungsgemässen Verfahren Zinnstrukturen aufgebracht werden. Die photosensitive Eigenschaft der Polyimidfilme vereinfacht dabei deren Strukturierung beträchtlich.

Es ist natürlich auch möglich, gemäss der Erfindung Zwischenlagen einer Mehrlagenschaltung mit gewünschten Zinnstrukturen zu versehen.

Die Erfindung lässt sich in vielen Bereichen anwenden, wovon nachfolgend nur die wichtigsten genannt werden:
- Mehrlagentechnik,
- Chip Carrier Technik,
- Folienschalter,
- flexible Leiterplatten
- dreidimensionale Formkörper mit Leiterbahnen.

Insgesamt liegt mit der Erfindung ein Verfahren vor, mit welchem sich auf einfache Weise Dünnschichtschaltungen mit Zinnstrukturen herstellen lassen. Hervorzuheben ist die Kompatibilität mit Mehrlagentechnologie.

## BEZEICHNUNGSLISTE

1 Keramik
2 Polyimidschicht
3 Grundmetallisierung
4, 8 Photolack
5 nichtabgedeckter Bereich
6 Leiterbahn
7 Substrat
9 Zinnstruktur

## Ansprüche

1. Verfahren zum Herstellen von Dünnschichtschaltungen mit Zinnstrukturen, bei welchem ein Substrat mit einer nicht-leitenden Oberfläche gemäss einem semi-additiven Verfahren selektiv mit einer Leiterbahn beschichtet wird und dann Zinnstrukturen auf die Leiterbahn aufgebracht werden, dadurch gekennzeichnet, dass

a) die Oberfläche des Substrats (7) mittels einer Plasmabehandlung vorgereinigt wird,

b) eine haftvermittelnde Grundmetallisierung (3) aus CuCr ganzflächig auf die Oberfläche aufgesputtert wird,

c) die Grundmetallisierung gemäss der semi-additiven Technik selektiv mit einem gutleitenden Metall galvanisch verstärkt wird,

d) die Leiterbahn (6) selektiv mit Zinnstrukturen im Sinn der semi-additiven Technik beschichtet wird, indem zumindest die Leiterbahn (6) mit einem Photolack selektiv abgedeckt, dann galvanisch mit Zinn oder mit einer Zinnlegierung verstärkt wird und der Photolack entfernt wird, und

e) dass schliesslich ein nicht verstärkter Bereich der Grundmetallisierung (3) mit alkalischen Aetzmitteln weggeätzt wird.

2. Verfahren nach Anspruch 1, dadurch gekennzeichnet, dass als gutleitendes Metall Cu für die Leiterbahn verwendet wird.

3. Verfahren nach Anspruch 1, dadurch gekennzeichnet, dass als gutleitendes Metall Au für die Leiterbahn verwendet wird.

4. Verfahren nach Anspruch 1, dadurch gekennzeichnet, dass als gutleitendes Metall Sn oder eine Zinnlegierung für die Leiterbahn verwendet wird.

5. Verfahren nach Anspruch 1, dadurch gekennzeichnet, dass zum selektiven Verstärken der Grundmetallisierung gemäss der semi-additiven Technik

a) die Grundmetallisierung (3) in nicht zu verstärkenden Bereichem mit einem Photolack (4) abgedeckt wird,

b) die nicht mit Photolack (4) abgedeckten Bereiche (5) der Grundmetallisierung (3) zwecks Entfernen von Cr-Resten mit einem Chromätzmittel angeätzt werden und

c) dass die nicht mit Photolack (4) abgedeckten Bereiche (5) der Grundmetallisierung (3) galvanisch verstärkt werden.

6. Verfahren nach Anspruch 1, dadurch gekennzeichnet, dass Reste von Cr, welche beim Wegätzen eines nicht verstärktem Bereichs der Grundmetallisierung (3) zurückgeblieben sind, durch eine Aetzung in Kalium-Hexacyanoferrat während etwa 10 s weggeätzt werden.

7. Verfahren nach Anspruch 1, dadurch gekennzeichnet, dass ein Substrat (7) aus Polyimid oder aus einer mit Polyimid beschichteten Keramik verwendet wird.

8. Verfahren nach Anspruch 7, dadurch gekennzeichnet, dass ein photosensitives Polyimid verwendet wird.

9. Verfahren nach Anspruch 1, dadurch gekennzeichnet, dass ein Substrat (7) Keramik, Silizium, Quarz oder Glas verwendet wird.

10. Verfahren nach Anspruch 1, dadurch gekennzeichnet, dass die Oberfläche des Substrats (7) mit einer Argon-Plasmabehandlung vorgereinigt wird.

FIG.1

FIG.2

FIG.3

FIG.4

FIG.5

FIG.6

89/031

FIG.7

FIG. 8

FIG. 9

89/031

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | DE-A-3 837 009 (BBC BROWN BOVERI AG) * Zusammenfassung; Ansprüche 1,3,5,7-8; Spalte 3, Zeilen 22-47; Spalte 4, Zeilen 28-66 * --- | 1-3,7,9 ,10 | C 04 B 41/90 H 05 K 3/38 H 01 L 21/48 |
| Y | EP-A-0 215 557 (GOULD INC.) * Ansprüche 1,5,7-9; Seite 8, Zeile 13 - Seite 9, Zeile 19; Seite 10, Zeilen 14-22; Seite 11, Zeilen 2-5; Seite 12, Zeilen 10-13 * --- | 1-3,7,9 ,10 | |
| A | SOLID STATE TECHNOLOGY, Juli 1973, Seiten 36-40; R.E. HICKS: "Thin-film electroplated funnel thru-holes on polyimide resin and laminated boards" * Spalte 3, Zeile 50 - Spalte 4, Zeile 28; Spalte 6, Zeile 10 - Spalte 7, Zeile 12 * --- | 1-2,6-7 | |
| A | US-A-4 750 979 (GEE et al.) * Zusammenfassung; Anspruch 5; Spalte 1, Zeilen 38-51; Spalte 2, Zeilen 5-22; Spalte 3, Zeilen 29-61 * --- | 9 | RECHERCHIERTE SACHGEBIETE (Int. Cl.5) C 04 B 41 H 05 K 3 H 01 L 21 C 23 F 1 |
| A | THIRD IEEE/CHMT INTERNATIONAL ELECTRONIC MANUFACTURING TECHNOLOGY SYMPOSIUM, Anaheim, California, 12. - 14. Oktober 1987, Seiten 178-183, IEEE, New York, US; T. OHSAKI et al.: "A fine-line multilayer substrate with photo-sensitive polymide dielectric and electroless copper plated conductors" * Spalte 1, Zeile 56 - Spalte 4, Zeile 12 * --- -/- | 8 | |

Der vorliegende Recherchenbericht wurde für alle Patentansprüche erstellt

| Recherchenort | Abschlußdatum der Recherche | Prüfer |
|---|---|---|
| DEN HAAG | 25-04-1990 | OLSSON S.A. |

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | GB-A- 874 965 (PLANER LTD) <br> * Ansprüche 1-4,7; Spalte 4, Zeilen 82-126; Spalte 5, Zeilen 18-65 * <br> ----- | 9 | |
| | | | **RECHERCHIERTE SACHGEBIETE (Int. Cl.5)** |

Der vorliegende Recherchenbericht wurde für alle Patentansprüche erstellt

| Recherchenort | Abschlußdatum der Recherche | Prüfer |
|---|---|---|
| DEN HAAG | 25-04-1990 | OLSSON S.A. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
    Dokument